# EUROPÄISCHE PATENTSCHRIFT

(11) **EP 4 056 960 B1**
(45) Veröffentlichungstag und Bekanntmachung des Hinweises auf die Patenterteilung: **15.11.2023**
(21) Anmeldenummer: 21162099.2
(22) Anmeldetag: 11.03.2021
(51) Int. Cl.: G01F 1/66, B06B 1/06, G10K 11/02, H10N 30/80, H10N 30/87

(54) **ULTRASCHALLWANDLER ZUM SENDEN UND/ODER EMPFANGEN VON ULTRASCHALLWELLEN**
ULTRASONIC TRANSDUCER FOR TRANSMITTING AND / OR RECEIVING ULTRASONIC WAVES
CONVERTISSEUR ULTRASONIQUE PERMETTANT D'ÉMETTRE ET/OU DE RECEVOIR DES ONDES ULTRASONIQUES

(43) Veröffentlichungstag der Anmeldung: 14.09.2022
(73) Patentinhaber: SICK Engineering GmbH, 01458 Ottendorf-Okrilla (DE)
(72) Erfinder: Klemm, Markus, 01309 Dresden (DE); Starke, Eric, 01796 Pirna (DE)
(74) Vertreter: Ludewigt, Christoph

(56) Entgegenhaltungen:
- DE-A1-102007 010 500
- DE-A1-102007 037 088
- DE-A1-102009 046 148
- DE-A1-102009 046 149
- DE-A1-102009 053 535
- DE-A1-102010 030 189
- DE-B3-102008 055 123
- US-A1- 2004 200 056
- US-A1- 2021 048 323
- US-B2- 8 904 881

## Beschreibung

Die Erfindung betrifft einen Ultraschallwandler zum Senden und/oder Empfangen von Ultraschallwellen gemäß dem Oberbegriff des Anspruchs 1.

Um beispielsweise die Durchflussgeschwindigkeit eines Fluids in einer Leitung, vorzugsweise einem kreisrunden Rohr, zu bestimmen, gibt es neben verschiedenen physikalischen Prinzipien den Einsatz von Ultraschallwellen, die in die Leitung ausgesendet werden. Mittels des Differenzlaufzeitverfahrens kann die Durchflussgeschwindigkeit des strömenden Fluids und somit der Strömung bestimmt werden.

Hierbei werden Ultraschallwellenpakete von jeweils einem von zwei gegenüberliegenden Ultraschallwandlern ausgesandt bzw. empfangen. Die Ultraschallwandler sind an der Rohrwand in Strömungsrichtung beanstandet, einander gegenüberliegend angeordnet und definieren einen Messpfad, der somit in einem Winkel ungleich 90° zur Strömung des Fluids liegt.

Die durch das Fluid propagierenden Ultraschallwellenpakete werden in Strömungsrichtung beschleunigt und gegen die Strömungsrichtung abgebremst. Die resultierende Laufzeitdifferenz wird mit geometrischen Größen zu einer mittleren Fluidgeschwindigkeit verrechnet, mit der der Durchfluss des strömenden Fluids bestimmt wird.

Ein wichtiges und anspruchsvolles Anwendungsfeld sind Gaszähler für Erdgaspipelines, in denen wegen der immensen Gasmengen und des Rohstoffwerts schon geringste Abweichungen in der Messgenauigkeit zu deutlich merklichen Wertunterschieden zwischen tatsächlich beförderten und gemessenen Mengen führen können. Dies führt zu hohen monetären Differenzen.

Da Gase gegenüber einem Festkörper generell eine viel geringere akustische Impedanz haben, ist es sehr wichtig für die Messung von Gasen mittels Ultraschalltechnik, dass die zum Messen verwendeten Ultraschallwellen des Ultraschallwandlers ohne große Energieverluste in das Gas eingekoppelt werden. Das heißt, bei einer Einkopplung der Ultraschallwellen des Ultraschallwandlers mit einem hohen Energieverlust in das Gas würde sich eine Messgenauigkeit des Ultraschallwandlers stark verringern.

Daher stellt eine optimierte Einkopplung der Ultraschallwellen des Ultraschallwandlers in das Gas eine wichtige Eigenschaft des Ultraschallwandlers dar, um die geforderte Messgenauigkeit des Ultraschallwandlers in diesem Bereich der Großgasmengenmessung zu erfüllen.

Ein grundsätzlich geeigneter Ultraschallwandler ist beispielsweise aus EP 0 119 855 B2 bekannt und besteht grundsätzlich aus in der folgenden Reihenfolge aufgezählten Hauptelementen:
- eine auch allgemein unter der Bezeichnung "backing-layer" verstandene Trägerschicht, die zumeist aus Epoxy-basiertem Material gebildet ist;
- eine erste Elektrode, die an der Trägerschicht angeordnet ist;
- ein Piezoelement, das an die erste Elektrode angekoppelt ist und zur Erzeugung eines auszusendenden Ultraschalls dient;
- eine zweite Elektrode, die an das Piezoelement auf der anderen Seite angekoppelt ist und die zusammen mit der ersten Elektrode eine elektrische Spannung auf dem Piezoelement aufbringt, so dass das Piezoelement zur Erzeugung des Ultraschalls zum Schwingen angeregt wird;
- und eine auch allgemein unter der Bezeichnung "matching-layer" verstandene Anpassungsschicht, die an der zweiten Elektrode angeordnet ist und eine Impedanzanpassung zwischen dem Piezoelement und dem Fluid bzw. dem Gas ermöglicht, um den erzeugten Ultraschall in das Gas einzukoppeln bzw. von dem Gas auszukoppeln.

Bei der Herstellung des genannten Ultraschallwandlers stellen die unterschiedlichen Prozessschritte der Beschichtung der im Bereich von 100 bis 500 µm befindlichen Schichtdicken einen hohen Aufwand dar, so dass hohe Produktionskosten anfallen.

Zusätzlich ist eine genaue Reproduzierbarkeit des Ultraschallwandlers nur unter hohem Aufwand und damit Kosten gewährleistet. Eine elektrische Kontaktierung des Piezoelements über die erste und zweite Elektrode ist ferner durch die getrennten Prozessschritte schwierig durchführbar, was wiederum einen negativen Faktor für die Reproduzierbarkeit darstellt.

Da die Anpassungsschicht des Ultraschallwandlers dem zu vermessenden Fluid ausgesetzt ist, ist bei dem bekannten Ultraschallwandler eine zusätzliche Schutzschicht für die Anpassungsschicht vorgesehen, die einerseits die Anpassungsschicht vor beispielsweise mechanischer Beschädigung oder Verschmutzung schützt, aber andererseits die Impedanzanpassung der Anpassungsschicht verschlechtert. Um einer Verschlechterung vorzubeugen, muss die Schutzschicht aus einem besonderen Verbundmaterial bestehen bzw. speziell hergestellt werden.

US 2004/0200056 A1, DE 102007010500 A1, DE 102010030189 A1, DE 102008055123 B3, US 8904881 B2, US 2021/0048323 A1, DE 102007037088 A1 und DE 102009046149 A1 offenbaren jeweils einen Ultraschallwandler bzw. ein Verfahren zur Herstellung eines Ultraschallwandlers, der bzw. das aus dem oben beschriebenen Stand der Technik bekannt ist.

Aus der DE 102007037088 A1 ist ein Ultraschallwandler nach dem Oberbegriff des Anspruchs 1 bekannt.

Es ist eine Aufgabe der Erfindung, einen Ultraschallwandler zum Senden und/oder zum Empfangen von Ultraschallwellen in einem Fluid zur Verfügung zu stellen, der einfach und damit kostengünstig herstellbar ist.

Die Aufgabe wird erfindungsgemäß durch einen Ultraschallwandler mit den Merkmalen des Anspruchs 1 gelöst.

Hieraus ergibt sich der technische Vorteil, dass die aus der flexiblen Leiterplatte bestehende Anpassungsschicht zugleich eine Schutzschicht bildet, so dass kein besonderes Verbundmaterial oder keine Herstellung einer besonderen Schutzschicht erforderlich ist.

Ferner kann vorteilhafterweise gegenüber dem beschriebenen Stand der Technik auf die separate zweite Elektrode verzichtet werden, wodurch eine Senkung der Materialkosten bei der Herstellung des Ultraschallwandlers möglich ist.

Weiterhin ist gemäß einem bevorzugten Ausführungsbeispiel die leitfähige Schicht in Teilflächen geteilt, wobei jede Teilfläche eine separate elektrische Kontaktierung bildet. Dies ermöglicht eine einfache elektrische Kontaktierung der dem Fluid zugewandten Seite des Piezoelements, wodurch der Herstellungsprozess deutlich zusätzlich vereinfacht wird. Insbesondere besteht das Piezoelement aus mehreren Einzelelementen, wobei jedes Einzelelement eine jeweilige separate Kontaktierung mit der flexiblen Leiterplatte aufweist. Dadurch ist es vorteilhaft einfach, einen Ultraschallwandler, bestehend aus einzelnen ansteuerbaren Einzelelementen zur Verfügung zu stellen, wodurch der Ultraschallwandler als Wandlerarray ausgebildet ist, bei dem die einzelnen Elemente getrennt betrieben werden können.

Ferner ist die zweite Kontaktierung insbesondere vollflächig oder punktuell ausgebildet, so dass die Herstellung des Ultraschallwandlers noch weiter vereinfacht ist. Hierbei bedeutet 'vollflächig kontaktiert', dass eine gesamte elektrische Schicht der flexiblen Leiterplatte mittels beispielsweise einer Kontaktpaste mit dem Piezoelement elektrisch verbunden ist. 'Punktuell kontaktiert' bedeutet hierbei, dass zumindest ein ausgewählter Punkt der elektrisch leitfähigen Schicht der flexiblen Leiterplatte mit dem Piezoelement verbunden ist.

Die flexible Leiterplatte kann bei der Herstellung des Ultraschallwandlers leichte Verformungen, wie beispielsweise Biegung, leichter aufnehmen und ausgleichen, so dass die Genauigkeit der Herstellung des Ultraschallwandlers und damit die Reproduzierbarkeit im Industriemaßstab gewährleistet ist.

Da die flexible Leiterplatte als Anpassungsschicht in direktem Kontakt mit dem zu messenden Fluid, zumeist Gas, steht, weist die flexible Leiterplatte vorteilhafterweise eine aus Polyimid bestehende Basisschicht auf, die zum einen eine akustische Impedanz zwischen der akustischen Impedanz des Piezoelements und der akustischen Impedanz des Gases bereitstellt und zum anderen eine hohe Unempfindlichkeit gegen Umgebungseinflüsse, insbesondere Abrasion und Verschmutzung aufweist.

Da die akustische Impedanz der flexiblen Leiterplatte im Bereich zwischen der akustischen Impedanz des Piezoelements und der akustischen Impedanz des Fluids liegt, ist eine einfachere Impedanzanpassung zwischen dem Ultraschallwandler und dem zu messenden Fluid möglich. Vorteilhafterweise entspricht eine Dicke der flexiblen Leiterplatte insbesondere etwa 1/10 bis 1/4 der Ultraschallwellenlänge, bevorzugt etwa in einem Bereich von etwa 100 µm bis 300 µm. Hierbei entspricht die erwähnte Ultraschallwellenlänge einer Ultraschallwellenlänge, die innerhalb der flexiblen Leiterplatte bei einer Arbeitsfrequenz des Ultraschallwandlers übertragen wird.

Ferner weist gemäß einem bevorzugten Ausführungsbeispiel die flexible Leiterplatte auf der dem Piezoelement abgewandten Fläche eine Schutzschicht, insbesondere aus Kupfer, Stahl, Gold oder Aluminium auf, wodurch die Schutzeigenschaft der flexiblen Leiterplatte verbessert werden kann.

Um die Herstellung des Ultraschallwandlers weiter zu vereinfachen, bildet die flexible Leiterplatte auch eine Anschlussfahne für einen elektrischen Anschluss. Hierdurch kann die flexible Leiterplatte bei der Herstellung des Ultraschallwandlers einfacher elektrisch kontaktiert werden.

Bevorzugte Ausgestaltungen und Weiterbildungen sowie weitere Vorteile der Erfindung sind den Unteransprüchen, der nachfolgenden Beschreibung und den Zeichnungen zu entnehmen.

Im Folgenden wird die Erfindung anhand von Ausführungsbeispielen unter Bezugnahme auf die Zeichnungen im Einzelnen erläutert. In der Zeichnung zeigen:
- Fig. 1: eine schematische Schnittansicht eines bevorzugten Ausführungsbeispiels eines erfindungsgemäßen Ultraschallwandlers;
- Fig. 1A: eine vergrößerte, schematische Detailansicht des Ausführungsbeispiels aus Figur 1;
- Fig. 2: eine schematische Schnittansicht eines weiteren bevorzugten Ausführungsbeispiels des erfindungsgemäßen Ultraschallwandlers;
- Fig. 2A: eine vergrößerte, schematische Detailansicht des Ausführungsbeispiels der Figur 2; und
- Fig. 3: eine schematische Darstellung eines bevorzugten Ausführungsbeispiels einer flexiblen Leiterplatte des erfindungsgemäßen Ultraschallwandlers.

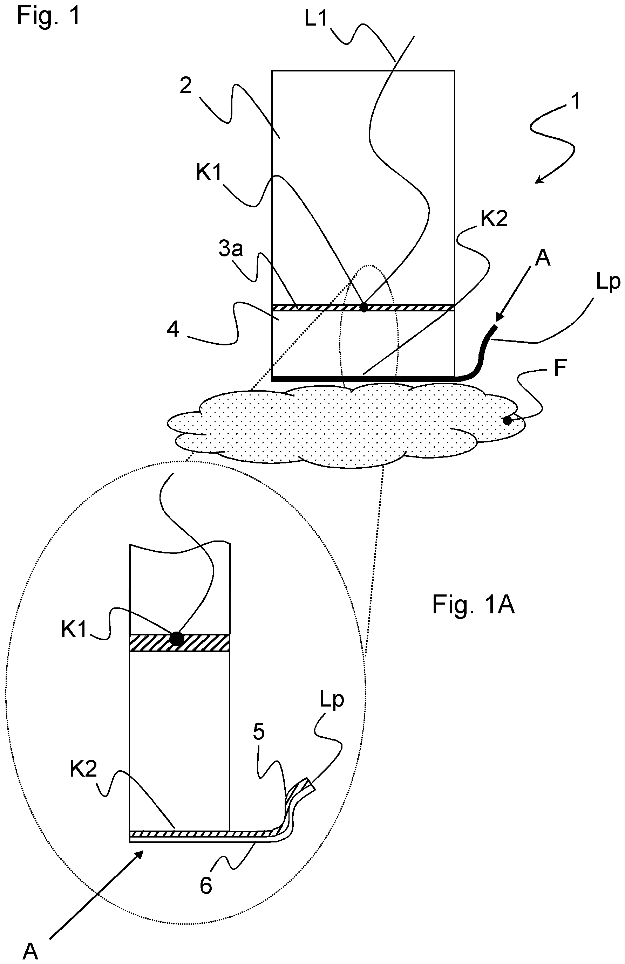

In Figur 1 ist eine schematische Schnittansicht eines bevorzugten Ausführungsbeispiels eines erfindungsgemäßen Ultraschallwandlers 1 gezeigt, der beispielsweise zum Messen einer physikalischen Größe eines Fluids F, insbesondere eines Gases, eingesetzt werden kann.

Der erfindungsgemäße Ultraschallwandler 1 weist eine Trägerschicht 2 auf, die auch als "backing layer" bezeichnet wird und dazu dient, eine Ultraschallabstrahlung auf einer dem Fluid F abgewandten Seite des Ultraschallwandlers 1 zu minimieren und ein Nachschwingen eines später noch näher beschriebenen Piezoelements zu verringern. Die Trägerschicht 2 ist vorzugsweise aus Epoxy-basiertem Material hergestellt.

An der Trägerschicht 2 ist eine erste Elektrode 3a angeordnet, die typischerweise als eine dünne Schicht aus beispielsweise Silber, Zinnbronze (CuSn) oder ähnlichem ausgebildet ist. Eine Dicke der ersten Elektrode 3 ist vorzugsweise kleiner als 10 µm.

An der ersten Elektrode 3a ist ein Piezoelement 4 angeordnet, dessen Dickenresonanz einer gewünschten Frequenz eines auszusendenden Ultraschalls entspricht, der für die Messungen in dem Fluid F genutzt wird.

Die erste Elektrode 3a ist somit zwischen der Trägerschicht 2 und dem Piezoelement 4 vorgesehen und stellt eine erste elektrische Kontaktierung K1 des Piezoelements 4 bereit, wobei diese der Trägerschicht 2 zugewandten Seite des Piezoelements 4 mittels einer schematisch dargestellten Leitung L1 über die erste elektrische Kontaktierung K1 mit einer nicht dargestellten Spannungsquelle verbunden ist.

Auf einer von der ersten Elektrode 3a abgewandten Seite des Piezoelements 4 ist eine Anpassungsschicht A vorgesehen, die zur Impedanzanpassung an das Fluid F dient. Das heißt mit anderen Worten, der akustische Zweck der Anpassungsschicht A besteht darin, eine Impedanzdifferenz zwischen der akustischen Impedanz des Fluids F, in das der Ultraschall abgestrahlt werden soll, und der akustischen Impedanz des Piezoelements 4 zu minimieren, so dass ein sogenannter Impedanzsprung zwischen dem Ultraschallwandler 1 und dem Fluid F nicht zu groß ist. Dadurch kann effektiv Energie in das Fluid F übertragen werden, so dass eine genauere Messung möglich ist.

Erfindungsgemäß ist die Anpassungsschicht A durch eine flexible Leiterplatte Lp gebildet, die auch eine zweite elektrische Kontaktierung K2 des Piezoelements 4 bereitstellt.

Durch die zweite elektrische Kontaktierung K2 mittels der flexiblen Leiterplatte Lp ist die dem Fluid F zugewandte Seite des Piezoelements 4 ebenfalls mit der nicht dargestellten Spannungsquelle verbunden, so dass durch die erste elektrische Kontaktierung K1 mittels der ersten Elektrode 3a und durch die zweite elektrische Kontaktierung K2 mittels der flexiblen Leiterplatte Lp eine elektrische Spannung an dem Piezoelement 4 angelegt werden kann, um das Piezoelement 4 zum Schwingen und damit zum Erzeugen von Ultraschallwellen zu bringen.

Wie in der Figur 1 dargestellt, steht die flexible Leiterplatte Lp in direktem Kontakt mit dem Fluid F, so dass die flexible Leiterplatte Lp sowohl die Anpassungsschicht A als auch eine Schutzschicht für den Ultraschallwandler 1 darstellt. Hierdurch kann eine Anzahl der zu verwendeten Komponenten reduziert werden, so dass Teilekosten und Herstellungskosten durch einen vereinfachteren Herstellungsprozess gesenkt werden können.

Die Figur 1A zeigt eine vergrößerte schematische Detailansicht des bevorzugten Ausführungsbeispiels des in der Figur 1 detailliert beschriebenen Ultraschallwandlers 1, wobei die flexible Leiterplatte Lp insbesondere zumindest eine elektrisch leitfähige Schicht 5 und zumindest eine elektrisch nicht-leitfähige Basisschicht 6 umfasst. Hierbei bilden die leitfähige Schicht 5 der flexiblen Leiterplatte Lp eine zweite Elektrode für die zweite elektrische Kontaktierung K2 des Piezoelements 4 und die elektrisch nicht-leitfähige Basisschicht 6 eine Anpassungs- und Schutzschicht für den Ultraschallwandler 1. Vorzugsweise kann die leitfähige Schicht 5 der flexiblen Leiterplatte Lp eine beispielweise aus Kupfer bestehende Leiterbahn der flexiblen Leiterplatte Lp sein.

Mit anderen Worten, die Leiterbahn der flexiblen Leiterplatte Lp fungiert als eine zweite Elektrode für das Piezoelement 4, so dass über die erste Elektrode 3a und die leitfähige Schicht 5 der flexiblen Leiterplatte Lp eine elektrische Spannung an das Piezoelement 4 angelegt werden kann.

Wie bereits erwähnt, dient die dem Fluid F zugewandte Basisschicht 6 der flexiblen Leiterplatte Lp als Anpassungsschicht A und zugleich als Schutzschicht für den Ultraschallwandler 1, wobei die Basisschicht 6 vorteilhafterweise aus Polyimid gebildet ist, so dass sie zum einen eine gute Impedanzanpassung an Gase ermöglicht und zum anderen eine hohe Unempfindlichkeit gegenüber beispielsweise mechanische bzw. chemische Abrasion oder Verschmutzung aufweist.

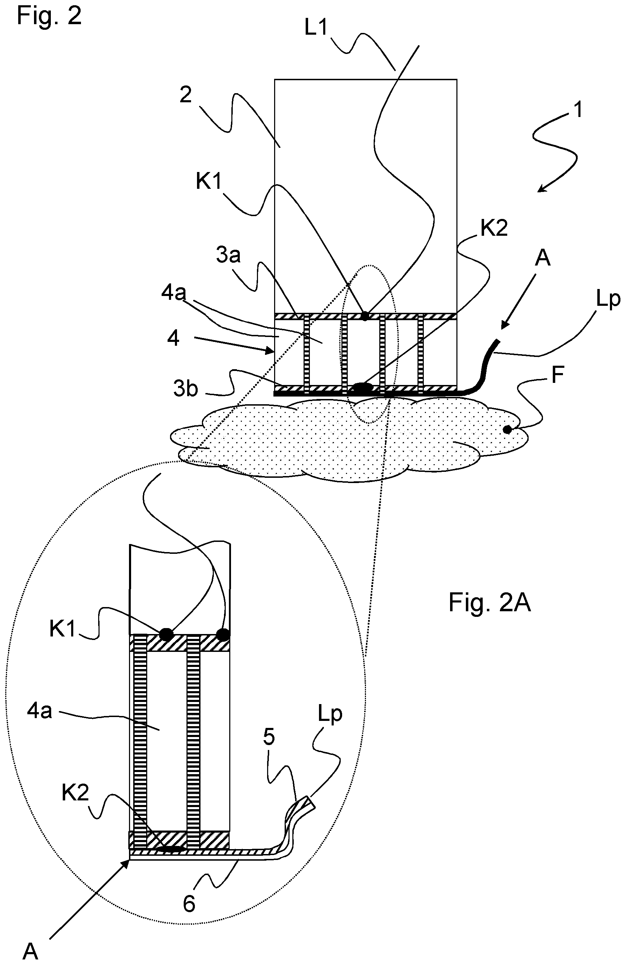

In der Figur 2 ist eine schematische Schnittansicht eines weiteren bevorzugten Ausführungsbeispiels eines erfindungsgemäßen Ultraschallwandlers 1 gezeigt, wobei die gleichen Komponenten wie bei dem in der Figur 1 dargestellten Ausführungsbeispiel die gleichen Bezugszeichen aufweisen.

Bei diesem Ausführungsbeispiel ist eine zweite Elektrode 3b vorgesehen, die wie die erste Elektrode 3a vorzugsweise aus einer dünnen Schicht besteht, wobei die dünne Schicht beispielsweise aus Silber, Zinnbronze (CuSn) oder ähnlichem ausgebildet ist. Die Dicke der zweiten Elektrode 3b ist vorzugsweise ebenfalls wie die erste Elektrode 3a kleiner als 10 µm. Hierbei ist die zweite Elektrode 3b mit der leitfähigen Schicht 5 der flexiblen Leiterplatte Lp, wie in der Figur 2A dargestellt, elektrisch verbunden, so dass die flexible Leiterplatte Lp zusammen mit der zweiten Elektrode 3b die zweite elektrische Kontaktierung K2 des Piezoelements 4 bereitstellt.

Durch die Möglichkeit einer elektrischen Verbindung zwischen der zweiten Elektrode 3b und der leitfähigen Schicht 5 der flexiblen Leiterplatte Lp ist die Herstellung des Ultraschallwandlers 1 vereinfacht. Die Herstellungsschritte sind einfacher ausführbar und in der Reihenfolge ihrer Ausführung tauschbar, nämlich zuerst eine Anordnung der zweiten Elektrode 3b an das Piezoelement 4 und dann eine elektrische Verbindung zwischen der zweiten Elektrode 3b mit der leitfähigen Schicht 5 der flexiblen Leiterplatte Lp oder zuerst die elektrische Verbindung zwischen der zweiten Elektrode 3b und der leitfähigen Schicht 5 der flexiblen Leiterplatte Lp und dann die Anordnung der zweiten Elektrode 3b zusammen mit der flexiblen Leiterplatte Lp an das Piezoelement 4.

Ferner besteht das Piezoelement 4 in diesem Ausführungsbeispiel aus mehreren Einzelelementen 4a, die jeweils eine separate Kontaktierung (nicht im Einzelnen dargestellt) mit der flexiblen Leiterplatte Lp aufweisen. Die leitfähige Schicht 5 der flexiblen Leiterplatte Lp ist dafür in Teilflächen geteilt, wobei jede Teilfläche eine separate elektrische Kontaktierung ermöglicht. Hierdurch ist das Piezoelement 4 mit seinen Einzelelementen 4a als Wandlerarray verwendbar.

Die leitfähige Schicht 5 der flexiblen Leiterplatte Lp kann an eine Struktur des Piezoelements 4 angepasst sein, so dass die flexible Leiterplatte Lp eine verbesserte mechanische Steifigkeit aufweist.

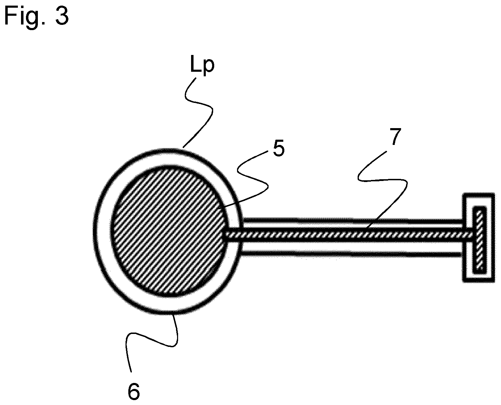

Die Figur 3 zeigt eine schematische Darstellung eines bevorzugten Ausführungsbeispiels der flexiblen Leiterplatte Lp des erfindungsgemäßen Ultraschallwandlers 1, bei dem die flexible Leiterplatte Lp einen kreisrunden Hauptteil aufweist, der an das Piezoelement 4 angebracht wird. Hierbei ist die flexible Leiterplatte Lp vorzugsweise durch Löten; Kleben mit elektrisch leitfähigem oder nicht-leitfähigem Kleber; Anheften mit Kontaktgel bzw. Kontaktfett oder Schweißen an dem Piezoelement 4 befestigt.

Bei dem dargestellten Ausführungsbeispiel der flexiblen Leiterplatte Lp weist die flexible Leiterplatte Lp eine Anschlussfahne 7 für einen elektrischen Anschluss mit der nicht dargestellten Spannungsquelle auf. Wie zuvor beschrieben, weist die Leiterplatte Lp die leitfähige Schicht 5 auf, die die zweite Kontaktierung K2 für das Piezoelement 4 bildet.

Die Anschlussfahne 7 ist in einfacher Weise Teil der Leiterplatte Lp und umfasst deshalb ebenso die Basisschicht 6 und die leitfähige Schicht 5, über die die Spannung von der Spannungsquelle zuführbar ist.

Die leitfähige Schicht 5 ist von der Basisschicht 6 nach außen, also zur von dem Piezoelement 4 abgewandten Seite, geschützt. Um die Schutzeigenschaften der Basisschicht 6 zu verbessern, kann diese aus mehreren elektrisch nicht-leitfähigen und elektrisch leitfähigen Schichten aufgebaut sein, so dass insbesondere eine nicht dargestellte Schutzschicht, insbesondere aus Kupfer, Stahl, Gold oder Aluminium, vorgesehen ist.

Trotz aller Schichten entspricht die Dicke der flexiblen Leiterplatte Lp vorzugsweise etwa 1/10 bis 1/4 der Ultraschallwellenlänge und liegt insbesondere in einem Bereich von etwa 100 µm bis 300 µm. Da eine flexible Leiterplatte bereits von sich aus eine für die Erfindung notwendige Basisschicht und eine leitfähige Schicht aufweist, ist der Herstellungsprozess des erfindungsgemäßen Ultraschallwandlers 1 vereinfacht, da mehrere Beschichtungsschritte entfallen können.

## Patentansprüche

1. Ultraschallwandler (1) zum Senden und/oder zum Empfangen von Ultraschallwellen in einem Fluid (F), umfassend
eine Trägerschicht (2),
eine Anpassungsschicht (A) zur Impedanzanpassung an das Fluid (F),
ein Piezoelement (4), das zwischen der Trägerschicht (2) und der Anpassungsschicht (A) angeordnet ist,
eine erste Elektrode (3a) zwischen der Trägerschicht (2) und dem Piezoelement (4), die eine erste elektrische Kontaktierung (K1) des Piezoelements (4) bereitstellt,
eine zweite Elektrode (3b), die eine zweite elektrische Kontaktierung (K2) des Piezoelements (4) bildet, wobei
die Anpassungsschicht (A) durch eine flexible Leiterplatte (Lp) gebildet ist und wobei
die flexible Leiterplatte (Lp) mindestens eine elektrisch leitfähige Schicht (5) und mindestens eine elektrisch nicht-leitfähige Basisschicht (6) umfasst, **dadurch gekennzeichnet, dass**
die leitfähige Schicht (5) der flexiblen Leiterplatte (Lp) eine beispielsweise aus Kupfer bestehende Leiterbahnen der flexiblen Leiterplatte (Lp) ist und dass die Leiterbahn der flexiblen Leiterplatte (Lp) als die zweite Elektrode (3b) fungiert.

2. Ultraschallwandler (1) nach Anspruch 1, **dadurch gekennzeichnet, dass** die flexible Leiterplatte (Lp) an eine Struktur des Piezoelements angepasst ist.

3. Ultraschallwandler (1) nach einem der vorhergehenden Ansprüche, **dadurch gekennzeichnet, dass** die flexible Leiterplatte (Lp) eine aus Polyimid bestehende Basisschicht (6) aufweist.

4. Ultraschallwandler (1) nach einem der vorhergehenden Ansprüche, **dadurch gekennzeichnet, dass** die flexible Leiterplatte (Lp) auf der dem Piezoelement (4) abgewandten Fläche eine Schutzschicht, insbesondere aus Kupfer, Stahl, Gold oder Aluminium aufweist.

5. Ultraschallwandler (1) nach einem der vorhergehenden Ansprüche, **dadurch gekennzeichnet, dass** das Piezoelement (4) aus mehreren Einzelelementen (4a) besteht, wobei jedes Einzelelement (4a) eine jeweilige separate Kontaktierung mit der flexiblen Leiterplatte (Lp) aufweist.

6. Ultraschallwandler (1) nach einem der vorhergehenden Ansprüche, **dadurch gekennzeichnet, dass** die flexible Leiterplatte (Lp) eine Anschlussfahne (7) für einen elektrischen Anschluss aufweist.

7. Ultraschallwandler (1) nach einem der vorhergehenden Ansprüche, **dadurch gekennzeichnet, dass** eine akustische Impedanz der flexiblen Leiterplatte (Lp) im Bereich zwischen einer akustischen Impedanz des Piezoelements (4) und einer akustischen Impedanz des Fluids (F) liegt.

8. Ultraschallwandler (1) nach einem der vorhergehenden Ansprüche, **dadurch gekennzeichnet, dass** eine Dicke der flexiblen Leiterplatte (Lp) etwa 1/10 bis 1/4 der Ultraschallwellenlänge entspricht, insbesondere in einem Bereich von etwa 100 µm bis 300 µm.

9. Ultraschallwandler (1) nach einem der vorhergehenden Ansprüche, **dadurch gekennzeichnet, dass** die flexible Leiterplatte (Lp) durch Löten; Kleben mit elektrisch leitbarem oder nicht leitbarem Kleber; Anheften mit Kontaktgel bzw. Kontaktfett oder Schweißen an dem Piezoelement (4) angebracht ist.

## Claims

1. Ultrasonic transducer (1) for transmitting and/or receiving ultrasonic waves in a fluid (F), comprising a support layer (2), a matching layer (A) for impedance matching to the fluid (F), a piezoelectric element (4) arranged between the support layer (2) and the matching layer (A), a first electrode (3a) between the support layer (2) and the piezo element (4), which provides a first electrical contact (K1) of the piezo element (4), a second electrode (3b) forming a second electrical contact (K2) of the piezo element (4), wherein the matching layer (A) is formed by a flexible printed circuit board (Lp) and wherein the flexible printed circuit board (Lp) comprises at least one electrically conductive layer (5) and at least one electrically non-conductive base layer (6),
**characterised in that**
the conductive layer (5) of the flexible printed circuit board (Lp) is a conductor track, for example consisting of copper, of the flexible printed circuit board (Lp) and **in that** the conductor track of the flexible printed circuit board (Lp) acts as the second electrode (3b).

2. Ultrasonic transducer (1) according to claim 1, **characterised in that** the flexible printed circuit board (Lp) is adapted to a structure of the piezo element.

3. Ultrasonic transducer (1) according to any one of the preceding claims, **characterised in that** the flexible printed circuit board (Lp) comprises a base layer (6) consisting of polyimide.

4. Ultrasonic transducer (1) according to one of the preceding claims, **characterised in that** the flexible printed circuit board (Lp) has a protective layer, in particular of copper, steel, gold or aluminium, on the surface facing away from the piezoelectric element (4).

5. Ultrasonic transducer (1) according to one of the preceding claims, **characterized in that** the piezoelectric element (4) consists of several individual elements (4a), each individual element (4a) having a respective separate contacting with the flexible printed circuit board (Lp).

6. Ultrasonic transducer (1) according to one of the preceding claims, **characterised in that** the flexible printed circuit board (Lp) has a terminal lug (7) for an electrical connection.

7. Ultrasonic transducer (1) according to any one of the preceding claims, **characterised in that** an acoustic impedance of the flexible printed circuit board (Lp) is in the range between an acoustic impedance of the piezo element (4) and an acoustic impedance of the fluid (F).

8. Ultrasonic transducer (1) according to one of the preceding claims, **characterised in that** a thickness of the flexible printed circuit board (Lp) corresponds to about 1/10 to 1/4 of the ultrasonic wavelength, in particular in a range of about 100 µm to 300 µm.

9. Ultrasonic transducer (1) according to one of the preceding claims, **characterised in that** the flexible printed circuit board (Lp) is attached to the piezo element (4) by soldering, gluing with electrically conductive or non-conductive adhesive, tacking with contact gel or contact grease or welding.

## Revendications

1. Transducteur à ultrasons (1) pour émettre et/ou recevoir d'ondes ultrasoniques dans un fluide (F), comprenant
une couche de support (2),
une couche d'adaptation (A) pour l'adaptation d'impédance au fluide (F),
un élément piézoélectrique (4) disposé entre la couche de support (2) et la couche d'adaptation (A),
une première électrode (3a) entre la couche de support (2) et l'élément piézoélectrique (4), qui fournit un premier contact électrique (K1) de l'élément piézoélectrique (4),
une deuxième électrode (3b) formant un deuxième contact électrique (K2) de l'élément piézoélectrique (4), dans lequel la couche d'adaptation (A) est formée par une carte imprimée flexible (Lp) et dans lequel la carte imprimée flexible (Lp) comprend au moins une couche électriquement conductrice (5) et au moins une couche de base électriquement non conductrice (6),
**caractérise en ce que**
la couche conductrice (5) de la carte imprimée flexible (Lp) est une piste conductrice, par exemple en cuivre, de la carte imprimée flexible (Lp) et **en ce que** la piste conductrice de la carte imprimée flexible (Lp) fonctionne comme la deuxième électrode (3b).

2. Transducteur à ultrasons (1) selon la revendication 1, **caractérisé en ce que** la carte imprimée flexible (Lp) est adapté à une structure de l'élément piézoélectrique.

3. Transducteur à ultrasons (1) selon l'une des revendications précédentes, **caractérisé en ce que** la carte imprimée flexible (Lp) comprend une couche de base (6) constituée de polyimide.

4. Transducteur à ultrasons (1) selon l'une des revendications précédentes, **caractérisé en ce que** la carte imprimée flexible (Lp) comprend sur la surface opposée à l'élément piézoélectrique (4) une couche de protection, notamment en cuivre, acier, or ou aluminium.

5. Transducteur à ultrasons (1) selon l'une des revendications précédentes, **caractérisé en ce que** l'élément piézoélectrique (4) consiste en plusieurs éléments individuels (4a), chaque élément individuel (4a) comprenant un contact séparé respectif avec la carte imprimée flexible (Lp).

6. Transducteur à ultrasons (1) selon l'une des revendications précédentes, **caractérisé en ce que** la carte imprimée flexible (Lp) comprend une languette de connexion (7) pour une connexion électrique.

7. Transducteur à ultrasons (1) selon l'une des revendications précédentes, **caractérisé en ce qu'**une impédance acoustique de la carte imprimée flexible (Lp) est située dans la plage entre une impédance acoustique de l'élément piézoélectrique (4) et une impédance acoustique du fluide (F).

8. Transducteur à ultrasons (1) selon l'une des revendications précédentes, **caractérisé en ce qu'**une épaisseur de la carte imprimée flexible (Lp) correspond à environ 1/10 à 1/4 de la longueur d'ondes ultrasoniques, en particulier dans une plage d'environ 100 µm à 300 µm.

9. Transducteur à ultrasons (1) selon l'une des revendications précédentes, **caractérisé en ce que** la carte imprimée flexible (Lp) est fixée à l'élément piézoélectrique (4) par brasage ; collage avec une colle électriquement conductrice ou non conductrice ; fixation avec un gel de contact ou une graisse de contact ou soudage.
